# EUROPÄISCHE PATENTANMELDUNG

(11) **EP 0 940 894 A2**
(43) Veröffentlichungstag der Anmeldung: **08.09.1999**
(21) Anmeldenummer: 99103343.2
(22) Anmeldetag: 20.02.1999
(51) Int. Cl.: H01S 3/02, H01S 3/025, H01S 3/16

(54) **Kunststoff-Substrat für Festkörper-Laser**

(30) Priorität: 06.03.1998 DE 19809696
(71) Anmelder: BAYER AG, 51368 Leverkusen (DE)
(72) Erfinder: Elschner, Andreas Dr., 45479 Mülheim (DE); Bruder, Friedrich-Karl Dr., 47800 Krefeld (DE); Wehrmann, Rolf Dr., 47800 Krefeld (DE); Mahrt, Rainer Dr., 35041 Marburg (DE); Scherf, Ulrich Dr., 55252 Mainz-Kastell (DE)

(57) **Zusammenfassung**

Es wird ein Träger (1) für einen Festkörperlaser auf Basis von organischem und/oder anorganischem Lasermaterial sowie ein Festkörperlaser beschrieben, bei dem der Träger (1) aus thermoplastischem oder duroplastischem Kunststoff besteht und an wenigstens einer Oberfläche (8) strukturiert ist, und wobei die strukturierte Oberfläche (8) des Trägers (1) ein periodisches Oberflächenprofil (9) aufweist.

## Beschreibung

Die Erfindung betrifft einen Träger für einen Festkörperlaser auf Basis von organischem und/oder anorganischem Lasermaterial sowie ein Festkörperlaser, bei dem der Träger aus thermoplastischem oder duroplastischem Kunststoff besteht und an wenigstens einer Oberfläche strukturiert ist, und wobei die strukturierte Oberfläche des Trägers ein periodisches Oberflächenprofil aufweist.

Seit Jahren werden Lösungen aus fluoreszierenden Molekülen in organischen Lösungsmitteln in Farbstofflasern eingesetzt. Die verwendeten fluoreszierenden Moleküle zeichnen sich durch eine hohe Fluoreszenzausbeute, einen breiten Abstimmbereich, eine hohe Stabilität gegen Oxidation und eine einfache Handhabung aus. Farbstofflaser finden eine weite Verbreitung und Anwendung weltweit. Sie kommen vor allem dort zum Einsatz, wo intensives, gerichtetes und monochromatisches Licht abstimmbar in einem breiten Wellenlängenbereich gefordert wird. Beispiele für Farbstofflaser sind in Schäfer, F.P.(ed.), Dye Lasers,2^{nd} ed., Topics in Applied Physics, Vol.1 (Springer, Berlin, Heidelberg, New York 1978) beschrieben.

Nachteilig sind bei Farbstofflasern die geringe Möglichkeit einer Maßstabsverkleinerung, ihr hoher Herstellungsaufwand, die vergleichsweise umständliche Handhabung der in den Farbstofflasern eingesetzten Farbstofflösungen und deren problematische Entsorgung. Gleichzeitig ist der Aufbau und die Justierung des optischen Resonators aufwendig und erfordert geschultes Personal. Diese Nachteile verhindern den Einsatz des Farbstofflasers als Massenprodukt, wie ihn Laserdioden aus anorganischen Materialien in den letzten Jahren in Anwendungen der Opto-Elektronik erfahren haben.

Die Entdeckung von Elektrolumineszenz in Polymerschichten (vergl. z.B. US-Patent 5 247 190) und aufgedampften Molekülschichten (vergl. z.B. die Patentschriften US 4 720 432 und US 4 539 507) und die dadurch initierten Aktivitäten haben ein großes Interesse für organische Leuchtdioden für Anwendungen im opto-elektronischen Bereich geweckt. Die erzielten Fortschritte in den letzten Jahren bei der Entwicklung organischer Leuchtdioden deuten auf eine baldige kommerzielle Anwendung hin. Die anfängliche Schwierigkeiten der schnellen Alterung organischer Leuchtdioden konnte durch Optimierung des Mehrschichtaufbaus, Weiterentwicklung der Kathoden und eine verbesserte Kapselung befriedigend gelöst werden. Ein erstes breites Anwendungsfeld für organische Leuchtdioden wird der Bereich selbstleuchtende Displays und flächige Hinterleuchtungen sein.

Die erzielte Effizienzsteigerung bei organischen Leuchtdioden läßt die Entwicklung organischer Laserdioden, die durch Anlegen eines elektrischen Feldes zur Lichtemission angeregt werden, in nächster Zukunft wahrscheinlich werden. Organische Laserdioden unterscheiden sich von organischen Leuchtdioden dadurch, daß es bei diesen zu verstärkter spontaner Emission kommt. Dies hat zur Folge, daß organische Laserdioden gerichtetes, polarisiertes Licht emittieren können. Das emittierte Licht ist außerdem schmalbandig hinsichtlich seiner Wellenlänge und die Strahlungsdichte ist höher als in organischen Leuchtdioden.

Bei elektrisch oder optisch angeregten Lasern kann durch spezielle Substrate oder Träger der Laserschwellwert erniedrigt und die Emissionswellenlänge definiert werden. Als besonders geeignet haben sich bei anorganischen Lasern (Halbleiterlasern) Substrate erwiesen, die einen DBR (Distributed Bragg Reflector, verteilter Bragg Reflektor) bzw. einen DFB (Distributed Feedback, verteilte Rückkopplung) bilden. Beiden Trägern ist gemein, daß sie über eine periodische Struktur verfügen, wobei die Periodizität in der Größenordnung der Wellenlänge des sichtbaren Lichts liegt, d.h. bei etwa 200 - 2000 nm.

Die periodische Struktur bei Trägern mit DBR besteht aus einem Vielschichtsystem, bei dem dünne Schichten mit unterschiedlichen Brechungsindices alternierend auf einen transparenten planparallelen Träger aufgebracht sind. Dieser Aufbau wurde erstmalig vorgestellt von I. P. Kaminov et al. Appl. Phys. Lett., 18, 497-499, (1971). Die verstärkte Lichtemission erfolgt bei Trägern mit DBR senkrecht zur Trägeroberfläche. Derartige Träger werden zum Aufbau von VCSELs (Vertical Cavity Surface Emitting Lasers), wie in 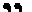 Jewell et al., Scientific American, Nov. 1991" beschrieben, eingesetzt. Technisch werden DBRs durch sukzessives Aufdampfen einzelner anorganischer Metalloxidschichten wie SiO₂ und TiO₂ hergestellt. Dieser Prozeß ist aufwendig und kostenintensiv.

Träger mit DFB haben dagegen eine periodisch strukturierte Oberfläche. Die verstärkte Lichtemission erfolgt bei DFB-Lasern parallel zur Oberfläche und senkrecht zur periodischen Struktur, wie in Kogelnik, H. Shank, C.V. 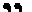 Stimulated Emission in a Periodic Structure", Appl.Phys. Lett. 18, 152-54 (1971) beschrieben. Technisch wird die periodische Oberflächenstruktur durch photolithographisches Ätzen anorganischer Substrate erzeugt, so daß eine wechselnde Abfolge von Erhöhungen und Erniedrigungen im Substrat entsteht. Dieser photolithographische Ätzprozeß ist aufwendig und teuer.

Es besteht daher die Aufgabe, einen Träger für eine Festkörperlaser zu entwickeln, der auf einfache Art herzustellen ist, und sich insbesondere zur Anwendung in Lasern mit organischem Lasermaterial eignet.

Die Aufgabe wird erfindungsgemäß durch einen Träger für einen Festkörperlaser auf Basis von organischem und/oder anorganischem Lasermaterial gelöst, der Gegenstand der Erfindung ist, und dadurch gekennzeichnet ist, daß der Träger aus thermoplastischem oder duroplastischem Kunststoff besteht und an wenigstens einer Oberfläche strukturiert ist, und daß die strukturierte Oberfläche des Trägers ein periodisches Oberflächenprofil aufweist.

Insbesondere weist der Träger an seiner strukturierten Oberfläche in mindestens einem Querschnitt durch den Träger periodisch angeordnete Erhebungen und Senken auf, wobei die Periodizität von 50 bis 10000 nm, bevorzugt von 80 nm bis 10000 nm, besonders bevorzugt von 80 nm bis 5000 nm und ganz besonders bevorzugt zwischen 100 nm bis 5000 nm beträgt.

Der Träger weist bevorzugt eine laterale Periodizität in mindestens einer Raumrichtung auf, wobei die Anzahl der Perioden mindestens 5, bevorzugt mindestens 10 beträgt.

Die Profiltiefe des Oberflächenprofils des Trägers beträgt in einer bevorzugten Ausführung von 1 nm bis 100 µm, bevorzugt von 5 nm bis 30 µm.

Die periodische Struktur der Oberfläche kann ein beliebiges Profil haben. Geeignet sind geometrische periodische Profile in einem Querschnitt durch die Oberfläche des Trägers wie Sinus-, Rechteck-, Trapez- oder Sägezahnprofil oder eine Kombination aus diesen Profilformen. Pyramidenstrukturen sind ebenfalls möglich. Besonders geeignet sind rechteck- und trapezförmige Profile.

Die Periodizität der Erhebungen und der Senken ist nicht auf eine einzelne Periodenlänge (Wellenlänge) beschränkt. Eine Überlagerung oder ein nebeneinander von bis zu 100 periodischer Profile unterschiedlicher Periodenlänge ist ebenfalls geeignet. Besonders geeignet ist eine Überlagerung von bis zu 10 periodischer Profile unterschiedlicher Periodenlänge.

Bevorzugter Kunststoff für den Träger ist ein Kunststoff ausgewählt aus der Reihe Polycarbonat, Poly(Methyl)acrylat, (Meth)acrylatcopolymere, Polystyrol und Styrolcopolymer, Poly-α-Metylstyrole, Acrylnitrilpolymer, Styrol-acrylnitril-copolymer, ABS, Vinylpolymer, Poly(cyclo)olefin, Polysulfon, Polyethersulfon, Polyester, Polyestercarbonat, Polyethercarbonate, Polyvinylchlorid und Polyvinylcarbazol.

Weitere Beispiele für geeignete thermoplastische und/oder duroplastische Materialien sind in 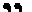 Encyclopedia of Polymer Science and Engineering", 2^{nd} Editon, John Wiley & Sons, und in Hans Domininghaus, 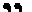 Die Kunststoffe und ihre Eigenschaften" 4. Auflage 1992, VDI-Verlag GmbH, Düsseldorf beschrieben. Generell sind alle transparenten Kunststoffmaterialien einsetzbar.

Als duroplastische Träger eignen sich insbesondere Reaktionsharze bei denen ein periodisches Oberflächenprofil durch Gießen, Pressen, Spritzgießen bzw. Reaction Injection Molding und Photopolymerisation auf mindestens einer der Oberflächen des Trägers erzeugt werden kann. Als Reaktionsharze sind alle nach den oben beschriebenen Verfahren verarbeitbaren Materialien geeignet, insbesondere solche mit geringem Volumenschwund während der Reaktion.

Der Träger kann nach verschiedenen Verfahren hergestellt werden, insbesondere durch Spritzgießen, Heißpressen, Gießen, Pressen, Reaktions-Spritzguß, Photopolymerisation oder Laser-Ablation.

Die Herstellverfahren für thermoplastische bzw. duroplastische Träger sind gegenüber den Herstellverfahren für konventionelle Substrate kostengünstiger und insbesondere für eine Massenfertigung geeignet.

Die erfindungsgemäßen Träger werden im Folgenden auch als thermoplastisches bzw. duroplastisches DFB-Substrat bezeichnet.

Die Herstellung eines erfindungsgemäßen thermoplastischen DFB-Substrats kann dadurch erfolgen, indem das in einer Matrize vorgegebene Oberflächenprofil durch Spritzgießen oder Heißpressen in dem thermoplastischen Träger abgeformt wird. Die Abformung von Oberflächenstrukturen mit den oben genannten Dimensionen ist mit Thermoplasten realisierbar, was z.B. an der analogen Herstellung einer einmal beschreibbaren Compact Disc (Rohling) grundsätzlich demonstriert werden kann. (Der Rohling weist z.B. eine typische Differenz zwischen Erhebung und Senkung von 150 nm, ein trapezförmiges Profil und eine Periode von 1600 nm auf.)

Die Herstellung eines erfindungsgemäßen duroplastischen DFB-Substrates kann auch dadurch erreicht werden, indem das in einer Matrize vorgegeben Oberflächenprofil in einem thermisch-, chemisch- oder photochemisch induziert aushärtendem Medium (Reaktionsharz) fixiert wird. Die Abformung von Oberflächenstrukturen mit den oben genannten Dimensionen ist ebenfalls realisierbar, was z.B. an der analogen Herstellung einer Double Layer Digital Versatile Disc (DVD) grundsätzlich demonstriert werden kann. (Diese weist z.B. eine typische Differenz zwischen Erhebung und Senkung von 80 nm, ein trapezförmiges Profil der Pits und eine Periode von 780 nm auf.) Weitere Beispiele für grundsätzlich geeignete Formverfahren finden sich in Haisma, J. Verheijen, M. van den Heuvel, K. van den Berg, J. "Mold-assisted nanolitography: A process for reliable pattern replication", J. Vac. Sci. Technol. B (146), Nov/Dec 1996.

Die Herstellung der Matrize kann durch grundsätzlich bekannte Verfahren, wie Photoresist-, Non-Photoresist- und Direct Metal-Mastering erfolgen wie in Pohlmann, K. "Compact Disc Handbuch", IWT Verlag GmbH Vaterstetten bei München, (1994) beschrieben.

Weiterer Gegenstand der Erfindung ist ein Festkörperlaser auf Basis von organischem und/oder anorganischem Lasermaterial bestehend wenigstens aus einem an seiner Oberfläche strukturierten Träger und einer auf dem strukturierten Träger angebrachten Schicht eines organischen und/oder anorganischen Lasermaterials dadurch gekennzeichnet, daß der strukturierte Träger aus thermoplastischem oder duroplastischem Kunststoff besteht, und daß die Oberflächenstruktur des Trägers ein periodisches Oberflächenprofil aufweist.

Das thermoplastische bzw. duroplastische DFB-Substrat gemäß der Erfindung kann zum Aufbau eines Lasers aus organischem und/oder anorganischem Lasermaterial benutzt werden.

Eine bevorzugte Form des Festkörperlasers ist dadurch gekennzeichnet, daß der Träger ein erfindungsgemäßer Träger ist und das Lasermaterial auf der strukturierten Oberfläche des Trägers angebracht ist.

Bevorzugt ist die strukturierte Oberfläche mit einer zusätzlichen anorganischen, insbesondere metallischen, Zwischenschicht versehen.

Die Zwischenschicht besteht insbesondere aus einem Metall aus der Reihe Aluminium, Silber, Kupfer, Magnesium und Gold oder aus einem Oxid aus der Reihe Titandioxid, Aluminiumoxid, Siliziumdioxid und Indium-Zinnoxid.

Unterschieden werden zwei denkbare, verschiedene Aufbauten eines bevorzugten Festkörperlasers, die von der Art der Anregung des Lasers (d.h. vom Pumpprozess) abhängen:

### 1. Optisch gepumpter organischer Laser:

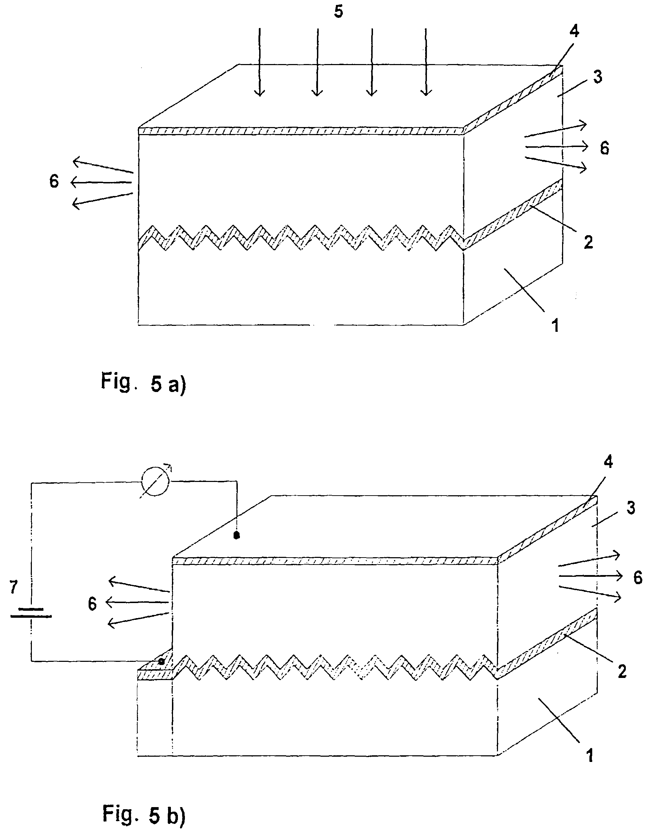

Im Fall eines optisch gepumpten organischen Lasers kann der Aufbau wie in Fig. 5a dargestellt, aussehen: Auf das periodische Höhenprofil des erfindungsgemäßen DFB-Substrats werden eine oder mehrere organische Schichten aufgebracht von der mindestens eine Schicht photolumineszierend ist. Das Aufbringen der einzelnen Schichten kann durch bekannte Verfahren wie beispielsweise Beguß, Spincoating. Laminieren oder thermisches Bedampfen erfolgen. Zwischen dem organischen Schichtsystem und dem thermoplastischen DFB-Substrat können weitere Schichten liegen, z.B. aufgedampfte Metall- oder Isolatorschichten. Geeignet sind Schichtdicken von 2 - 10000 nm, bevorzugt 10 - 5000 nm. Das organische Schichtsystem hat insbesondere eine Dicke von 5 - 50000 nm, bevorzugt von 10 - 20000 nm, besonders bevorzugt von 10 bis 10000 nm. Auf das organische Schichtsystem kann auch eine semitransparente Metallschicht als Reflexionsschicht aufgebracht werden.

Der organische Laser wird optisch angeregt (gepumpt), indem beispielsweise das Laserlicht eines Anregungslasers mit einer Zylinderlinse senkrecht zu den periodischen Erhebungen fokussiert wird. Die Lichtemission des organischen Lasers tritt dann an den Stirnflächen parallel zur Oberfläche und senkrecht zur periodische Struktur aus.

### 2. Elektrisch gepumpter organischer Laser:

Im Fall eines elektrisch gepumpten organischen Lasers kann der Aufbau wie in Fig. 5b dargestellt, aussehen: Auf das periodische Höhenprofil eines erfindungsgemäßen DFB-Substrats ist eine Elektrode aufgebracht. Diese Elektrode kann aus einem transparenten leitfähigen Oxid (z.B. ITO) bestehen oder aus einer aufgedampften Metallschicht. Geeignet sind Schichtdicken von 2 - 10000 nm, bevorzugt 10 - 5000 nm. Auf diese Elektrode werden eine oder mehrere organische Schichten aufgebracht wobei eine der Schichten photolumineszierend ist. Das Aufbringen der einzelnen Schichten kann entweder durch bekannte Verfahren, beispielsweise durch Beguß, Spincoating, Laminieren, Druck oder durch thermisches Bedampfen erfolgen. Als Gegenelektrode wird auf dieses organische Schichtsystem eine Metallschicht oder ein transparentes leitfähiges Oxid (z.B. ITO) aufgebracht. Die Schichtdicke des organischen Schichtsystems zwischen den Elektroden beträgt von 5 - 5000 nm, bevorzugt von 10 - 2000 nm, besonders bevorzugt von 20 - 1000 nm.

Der organische Laser wird elektrisch angeregt, indem eine elektrische Spannung an die beiden Elektroden angelegt wird, welche einen Strom durch das organische Schichtsystem fließen läßt. Die Emission tritt an den Stirnflächen parallel zur Oberfläche und senkrecht zu den periodischen Strukturen aus.

Ein bevorzugter Festkörperlaser ist dadurch gekennzeichnet, daß er mindestens eine laseraktive Schicht aufweist, die ganz oder zum Teil ein organisches Material umfaßt und photofluoreszierende Eigenschaften besitzt. Geeignet sind Materialien, die bevorzugt aus Lösung auf den Träger gebracht werden können, wie konjungierte Polymere, z.B. Poly(Phenylenvinylene), substituierte Poly(Phenylenvinylene) MEH-PPV, Poly(Phenylenvinylencopolymere), Poly(Paraphenylene), Poly(Thiophene) oder Hauptketten- und Seitenkettenpolymere mit photofluoreszierenden Bausteinen, z.B. Distyrylene, ferner Mischungen aus polymeren Bindern z.B. Polystyrol, Polycarbonat, PMMA mit fluoreszierenden Verbindungen, z.B. Cumarine, Perylene, Phthalocyanine oder anderen fluoreszierenden Oligomeren, z.B. Phenylenvinylene, oder mit fluoreszierenden anorganischen Verbindungen, z.B. CdS, CdSe. Ebenfalls geeignet sind Materialien, die bevorzugt auf den Träger gedampft oder aus Lösung aufgebracht werden können, wie niedermolekulare fluoreszierende Verbindungen, z.B. Cumarine, Perylene, Phthalocyanine, Stilbene, Distilbene oder Metallkomplexe, z.B. Tri(8-hydroxychinolin)-Aluminium.

Der erfindungsgemäße Laser kann überall dort eingesetzt werden, wo gerichtetes, intensives, monochromatisches, polarisiertes Licht benötigt wird. Ein spezieller Vorteil von organischen Laserdioden gegenüber anorganischen Laserdioden ist die Möglichkeit die lichtemittierenden Schichten durch einfachere und damit wirtschaftlichere Prozesse aufzubringen, wie Aufdampfen oder Aufcoaten. Dieses Verfahren führt zu deutlich niedrigeren Herstellungskosten. Ein weiterer Vorteil ist, daß bei organischen Laserdioden die Wellenlänge der Laseremission innerhalb der spektral breiten Emissionsbande des organischen Materials einstellbar ist, ähnlich wie beim Farbstofflaser, und nicht nur auf eine Wellenlänge beschränkt ist.

Der erfindungsgemäße thermoplastische bzw. duroplastische Träger mit einer periodischen Oberflächenstruktur kann aufgrund seiner einfachen Herstellung als kostengünstiges Substrat für organische DFB-Laser verwendet werden. Er eignet sich insbesondere für die Massenfertigung. Die DFB-Struktur des thermoplastischen bzw. duroplastischen Trägers erlaubt eine gezielte Wellenlängenselektion des emittierten Lichts, eine Verschmälerung der Halbwertsbreite des emittierten Lichts und führt übertaschenderweise zu einer Absenkung des Laserschwellwerts.

Die Erfindung wird nachstehend anhand der Figuren beispielhaft näher erläutert. Es zeigen:
- Fig. 1: Eine schematische Darstellung einer trapezförmigen Rille im Träger 1.
- Fig. 2: Die Intensität der Emission eines erfindungsgemäßen Festkörperlasers nach Beispiel 1 in Abhängigkeit von der Wellenlänge.
- Fig. 3: Die Intensität der Emission bei 493 nm in Abhängigkeit von verschiedenen Pumpenergien.
- Fig. 4: Eine schematische Darstellung des Trägers 1.
- Fig. 5: Eine schematische Darstellung des erfindungsgemäßen Festkörperlasers
der a) optisch gepumpt
oder b) elektronisch gepumpt wird.

### Beispiele

Ein mit dem erfindungsgemäßen Träger aufgebauter Laser hat z.B. folgenden Aufbau (Fig. 5a).

Auf den Träger 1 aus Kunststoff ist eine Metallschicht 2 aufgebracht, die den Träger 1 von der Laserschicht 3 trennt. Auf der Laserschicht 3 ist noch eine halbtransparente Reflexionsschicht 4 möglich.

In einer Variante (Fig. 5b) wird das Lasermaterial 3 mittels elektrischem Strom aus einer Stromquelle 7 durch die Schichten 2 und 4 angeregt werden, um eine Besetzungsinversion im Material 3 zu erzeugen.

### Beispiel 1:

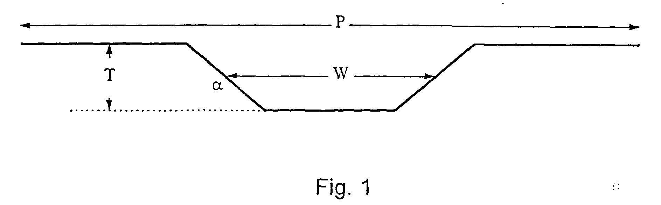

Zur Herstellung eines thermoplastischen DFB Trägers 1 wurde ein runder Rohling spritzgegossen, der auch für einmal beschreibbare Compact Discs (CD-Recordable) grundsätzlich verwendbar ist. Die Herstellung erfolgte über die Abformung der Oberflächenstruktur einer Matrize im Spritzguß. Als Trägermaterial wurde Polycarbonat verwendet. Der Rohling besaß auf einer Fläche eine spiralförmig von Innen nach Außen laufende Rille (Groove). Die Rillen 11 lagen so dicht, daß sie in radialer Richtung als parallel angenommen werden können. Die Periode P der Rillen-Struktur war in radialer Richtung gesehen 1600 nm. Die Rillen 11 besaßen einen trapezförmigen Querschnitt. Der Böschungswinkel a betrug 36°. Die Tiefe T der Rillen 11 betrug 145 nm, die Weite W an der halben Tiefe der Rillen 11 betrug 500 nm. (siehe Fig. 1)

Die Oberfläche mit der Periodischen Struktur des auf diese Weise hergestellten Substrats 1 wurde in einer Aufdampfanlage (Leybold) ganzflächig mit einer Aluminiumschicht 2 bedampft. Während des Aufdampfens herrschte in der Apparatur ein Druck von < 1Pa. Die Schichtdicke der Aluminiumsschicht betrug 100 nm.

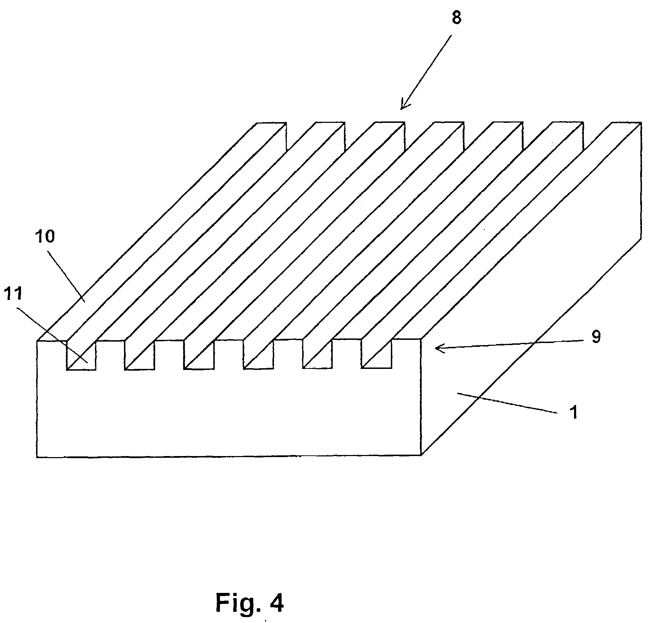

Das Substrat 1 wurde in kleine etwa 1 cm² große quadratische Stücke (siehe Fig. 4), die eigentlichen Träger für den Laser, geschnitten. Die Schnittkanten wurden mit einer Fräsmaschine nachgearbeitet.

Auf diese Substrate 1 wurde ein dünner Film 3 eines fluoreszierenden Polymers aufgebracht. Es handelte sich dabei um ein Leiterpolymer, wie von U.Scherf und K. Müllen in Makromol. Chem.Rapid Commun. 12 (1991) 489 beschrieben. Eine 2 %-ige Lösung dieses Polymers in Chloroform wurde mittels Spritzenaufsatzfiltern mit Porengröße 0.2 µm gereinigt. Die gefilterte Lösung wurde auf das Substrat aufgebracht und mit einer Lackschleuder (spin-coater) wurde unter Reinraumbedingungen (Reinraumklasse 1000) die überstehende Lösung abgeschleudert. Die Umdrehungsgeschwindigkeit des Spin-Coaters betrug 1800 U/min. Der getrocknete Polymerfilm 3 hatte eine Schichtdicke von ca. 100 nm ± 10 %. Die so erhaltenen Proben wurden unter Schutzgasatmosphäre aufbewahrt. Anschließend wurde unter gleichen Bedingungen eine Kontrollprobe auf einem Quarzglas-Substrat hergestellt.

Zur optischen Charakterisierung der Proben wurden dieselben auf einem Probenhalter befestigt. Mittels eines durchstimmbaren XeCl-Excimerlaser gepumpten Farbstofflaser Systems (Lambda Physics), welches auf eine Emissionswellenlänge von 450 nm justiert war, wurden die Proben angeregt. Das Anregungslicht 5 wurde mittels einer Zylinderlinse der Brennweite 3 cm, auf die Probe fokussiert. Die Dimension des Lichtfleckes betrug 1cm x 50 µm. Alle Experimente wurden an Luft bei Raumtemperatur durchgeführt. Das an der Stirnfläche der Probe austretende Licht 6 wurde mit einem optischen Multikanal Analysator mittels CCD-Kamera aufgezeichnet. Die Pulslänge des Anregungslasers betrug 10 ns. Die Intensität des Anregungslasers wurde mittels Neutralglasfiltern eingestellt. Die Energie pro Puls wurde mit einem Energiemeßgerät bestimmt.

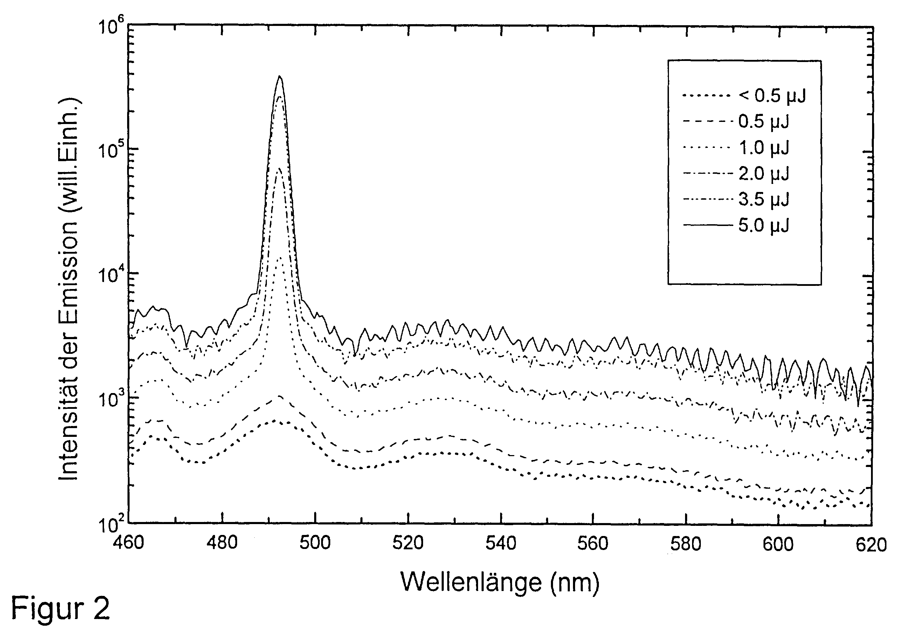

Der spektrale Verlauf des von dem Festkörperlaser (mit DFB Substrat) emittierten Lichts ist für verschiedenen Pulsenergien in Fig. 2 dargestellt. Deutlich zu erkennen, ist das Herauswachsen einer schmalbandigen Emission mit einem Maximum bei 493 nm für Pulsenergien E > 0.5µJ . Bei E=5µJ beträgt die Halbwertsbreite dieser schmalen Bande 2,5 nm, wobei die spektrale Auflösung des Detektionssystems etwa 2 nm beträgt. Die Emissionsbande bei 493 nm beträgt 25 nm wenn mit Energien kleiner 0,5µJ angeregt wird.

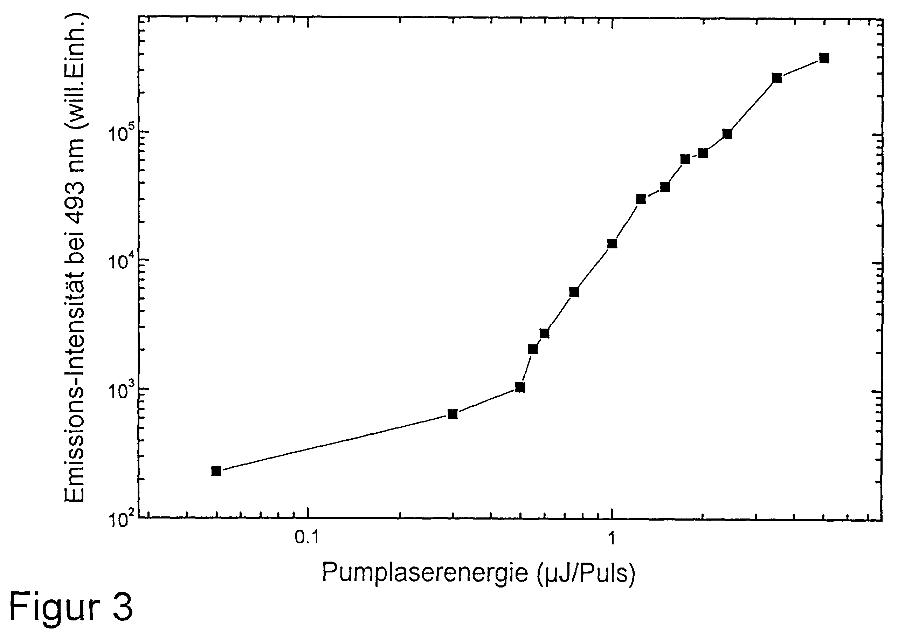

In Fig. 3 ist die Intensität des emittierten Licht bei 493 nm gegen die Pumpenergie in doppelt logarithmischen Maßstab aufgetragen. Bei dieser Auftragung markiert der Knick in den Steigungen bei 0.5µJ/Puls den Einsatzwert für die Laseremission (Schwellwert). Bei der Kontrollprobe auf einem nicht erfindungsgemäßen Quarzträger liegt der Schwellwert bei 20µJ und die Halbwertsbreite der Emissionsbande mit einem Maximum bei 493nm beträgt 4,5nm für eine Pulsenergie von 50µJ.

Aus den Ergebnissen folgt, daß die Verwendung eines spritzgegossenen thermoplastischen DFB Substrates 1 zu einer starken Absenkung des Emissionsschwellenwertes für die Laseremission führt und sogar zu einer Verschmälerung der Linienbreite der Emission gegenüber einem Laser mit einem konventionellen Quarzsubstrat.

## Patentansprüche

1. Träger (1) für einen Festkörperlaser auf Basis von organischem und/oder anorganischem Lasermaterial dadurch gekennzeichnet, daß der Träger (1) aus thermoplastischem oder duroplastischem Kunststoff besteht und an wenigstens einer Oberfläche (8) strukturiert ist, und daß die strukturierte Oberfläche (8) des Trägers (1) ein periodisches Oberflächenprofil (9) aufweist.

2. Träger gemäß Anspruch 1, dadurch gekennzeichnet, daß der Träger (1) an seiner strukturierten Oberfläche (8) in mindestens einem Querschnitt durch den Träger (1) periodisch angeordnete Erhebungen (10) und Senken (11) aufweist, wobei die Periodizität von 50 bis 10000 nm beträgt.

3. Träger gemäß Anspruch 2, dadurch gekennzeichnet, daß die Periodizität der Erhebungen (10) und Senken (11) von 80 nm bis 10000 nm, bevorzugt von 80 nm bis 5000 nm und besonders bevorzugt zwischen 100 nm bis 5000 nm beträgt.

4. Träger nach einem der Ansprüche 1 bis 3, dadurch gekennzeichnet, daß der Träger (1) eine laterale Periodizität in mindestens einer Raumrichtung aufweist, wobei die Anzahl der Perioden mindestens 5, bevorzugt mindestens 10 beträgt.

5. Träger nach einem der Ansprüche 1 bis 4, dadurch gekennzeichnet, daß die Profiltiefe des Oberflächenprofils (9) von 1 nm bis 100 µm, bevorzugt von 5 nm bis 30 µm beträgt.

6. Träger nach einem der Ansprüche 1 bis 5, dadurch gekennzeichnet, daß das Oberflächenprofil (9) in einem Querschnitt durch die Oberfläche des Trägers (1) ein Sinus-, Rechteck-, Trapez- oder Sägezahnprofil oder eine Kombination aus diesen Profilformen ist, insbesondere ein rechteck- und trapezförmiges Profil.

7. Träger nach einem der Ansprüche 1 bis 6, dadurch gekennzeichnet, daß das periodische Oberflächenprofil (9) im Querschnitt durch die Oberfläche des Trägers (1) wenigstens eine, insbesondere wenigstens zehn, unterschiedliche Periodenlängen aufweist.

8. Träger nach einem der Ansprüche 1 bis 7, dadurch gekennzeichnet, daß der Kunststoff für den Träger (1) ausgewählt ist aus der Reihe Polycarbonat, (Methyl)acrylcopolymer, Polystyrol und Styrolcopolymere, bevorzugt Polyα-Methylstyrol, Acrylnitrilpolymer, Styrol-acrylnitril-copolymer, ABS, Vinylpolymer, Poly(cyclo)olefin, Polysulfon, Polyethersulfon, Polyester, Polyestercarbonat, Polyethercarbonat, Polyvinylchlorid und Polyvinylcarbazol.

9. Träger nach einem der Ansprüche 1 bis 8, dadurch gekennzeichnet, daß der Träger (1) durch Spritzgießen, Heißpressen, Gießen, Pressen, Reaktions-Spritzguß, Photopolymerisation oder Laser-Ablation hergestellt ist.

10. Festkörperlaser auf Basis von organischem und/oder anorganischem Lasermaterial bestehend wenigstens aus einem an seiner Oberfläche strukturierten Träger (1) und einer auf dem strukturierten Träger (1) angebrachten Schicht (3) eines organischen und/oder anorganischen Lasermaterials, dadurch gekennzeichnet, daß der strukturierte Träger (1) aus thermoplastischem oder duroplastischem Kunststoff besteht, und daß die Oberflächenstruktur des Trägers ein periodisches Oberflächenprofil (9) aufweist.

11. Festkörperlaser nach Anspruch 10, dadurch gekennzeichnet, daß der Träger ein Träger (1) nach einen der Ansprüche 1 bis 9 ist und das Lasermaterial (3) auf der strukturierten Oberfläche (8) angebracht ist.

12. Festkörperlaser nach einem der Ansprüche 10 oder 11, dadurch gekennzeichnet, daß die strukturierte Oberfläche (8) mit einer zusätzlichen anorganischen, insbesondere metallischen, Zwischenschicht (2) versehen ist.

13. Festkörperlaser nach Anspruch 12, dadurch gekennzeichnet, daß die Zwischenschicht (2) aus einem Metall aus der Reihe Aluminium, Silber, Kupfer, Magnesium und Gold oder aus einem Oxid aus der Reihe Titandioxid, Aluminiumoxid, Siliziumdioxid und Indium-Zinkoxid besteht.

14. Festkörperlaser nach einem der Ansprüche 10 bis 13, dadurch gekennzeichnet, daß das Lasermaterial 3 ganz oder zum Teil aus einem organischen Material besteht, das photofluoreszierende Eigenschaften besitzt, bevorzugt konjungierte Polymere, besonders bevorzugt Poly(Phenylenvinylen), bevorzugt substituierte Poly(Phenylenvinylen), besonders bevorzugt MEH-PPV, bevorzugt Poly(Phenylenvinylencopolymere), Poly(Paraphenylene), Poly(Thiophene) oder bevorzugt Hauptketten- und Seitenkettenpolymere mit photofluoreszierenden Bausteinen, besonders bevorzugt Distyrylene, ferner bevorzugt Mischungen aus polymeren Bindern mit fluoreszierenden Molekülen, besonders bevorzugt Cumarine, Perylene, Phthalocyanine oder mit anderen fluoreszierenden Oligomeren, bevorzugt Phenylenvinylene, oder fluoreszierenden anorganischen Verbindungen, besonders bevorzugt CdS, CdSe.

15. Festkörperlaser nach einem der Ansprüche 10 bis 13, dadurch gekennzeichnet, daß das Lasermaterial 3 ein Material ist, das auf den Träger gedampft oder aus Lösung aufgebracht wird und eine niedermolekulare Verbindung enthält, bevorzugt aus der Reihe Cumarine, Perylene, Phthalocyanine, Stilbene, Distilbene oder Metallkomplexe, besonders bevorzugt Tri(8-hydroxychinolin)-Aluminium.
